# EUROPÄISCHE PATENTSCHRIFT

(11) **EP 3 326 216 B1**
(45) Veröffentlichungstag und Bekanntmachung des Hinweises auf die Patenterteilung: **04.11.2020**
(21) Anmeldenummer: 16733919.1
(22) Anmeldetag: 27.06.2016
(51) Int. Cl.: H01L 41/053, H01L 41/107

(54) **HALTERUNG FÜR EIN PIEZOELEKTRISCHES BAUELEMENT**
HOLDER FOR A PIEZOELECTRIC COMPONENT
SUPPORT POUR COMPOSANT PIÉZOÉLECTRIQUE

(30) Priorität: 23.07.2015 DE 102015112044
(43) Veröffentlichungstag der Anmeldung: 30.05.2018
(73) Patentinhaber: TDK Electronics AG, 81671 München (DE)
(72) Erfinder: DÖLLGAST, Bernhard, 8530 Deutschlandsberg (AT); PUFF, Markus, 8010 Graz (AT); KUDELA, Pavol, 8530 Deutschlandsberg (AT)
(74) Vertreter: Epping - Hermann - Fischer
(86) Internationale Anmeldenummer: PCT/EP2016/064833
(87) Internationale Veröffentlichungsnummer: WO 2017/012827

(56) Entgegenhaltungen:
- JP-A- H1 074 992
- JP-A- 2001 267 647
- JP-A- 2008 041 737
- JP-A- 2008 053 405
- US-A1- 2009 015 099
- US-A1- 2009 146 535
- US-A1- 2009 224 631

## Beschreibung

Die vorliegende Erfindung betrifft eine Halterung für ein piezoelektrisches Bauelement. Bei der Halterung kann es sich insbesondere um eine Halterung handeln, die zur mechanischen Aufhängung und elektrischen Kontaktierung eines piezoelektrischen Bauelementes geeignet ist.

Aus DE 2626708 A1 ist die Befestigung eines Schwingkristalls mit Hilfe von gabelförmigen Halteelementen bekannt, die mit dem Schwingkristall verlötet werden. Ein Nachteil dieser Lösung besteht jedoch darin, dass der Schwingkristall nicht demontierbar ist. Halterungen zum Einklemmen piezoelektrischer Bauelemente, wie etwa Transformatoren oder Ultraschallaktoren, mit Kontaktelementen aus leitfähigem Gummi sind beispielsweise aus US 2009/146535 A1, JP 2008-041737 A, JP 2008-053405 A, JP H10-74992 A, JP 2001-267647 A oder US 2009/224631 A1 bekannt.

Aufgabe der vorliegenden Erfindung ist es, eine verbesserte Halterung für ein piezoelektrisches Bauelement anzugeben. Diese Aufgabe wird durch den Gegenstand des vorliegenden Anspruchs 1 gelöst.

Es wird eine Halterung für ein piezoelektrisches Bauelement vorgeschlagen, die eine Klemmvorrichtung und zwei Kontaktelemente aufweist, wobei die Kontaktelemente ein leitfähiges Gummimaterial aufweisen. Insbesondere können Die Kontaktelemente aus dem leitfähigen Gummimaterial bestehen. Die Klemmvorrichtung ist ferner dazu ausgestaltet, das piezoelektrische Bauelement in einem geschlossenen Zustand zwischen den Kontaktelementen festzuklemmen, wobei die Kontaktelemente das piezoelektrische Bauelement im geschlossenen Zustand der Klemmvorrichtung elektrisch kontaktieren.

Durch das Festklemmen des piezoelektrischen Bauelementes zwischen den Kontaktelementen kann das piezoelektrische Bauelement mechanisch befestigt werden. Die Halterung ermöglicht somit in einfacher Weise, das piezoelektrische Bauelement elektrisch zu kontaktieren und mechanisch zu befestigen.

Die Halterung kann derart ausgestaltet sein, dass im geschlossenen Zustand der Klemmvorrichtung die Kontaktelemente unmittelbar an dem piezoelektrischen Bauelement anliegen. Die Kontaktelemente können dabei an einer Außenmetallisierung des piezoelektrischen Bauelementes anliegen und das piezoelektrische Bauelement auf diese Weise mit einer elektrischen Spannung versorgen. Bei der Außenmetallisierung kann es sich beispielsweise um eine Außenelektrode des Bauelements handeln.

Zwischen dem Kontaktelement und einer Außenfläche des piezoelektrischen Bauelementes kann vorzugsweise keine Reibung entstehen, wenn das piezoelektrische Bauelement zwischen den Kontakten festgeklemmt ist.

Das leitfähige Gummimaterial wirkt ferner aufgrund seiner elastischen Eigenschaften als Dämpfer. Aufgrund der elastischen Eigenschaften des leitfähigen Gummimaterials werden mechanische Schwingungen des zwischen den Kontaktelementen eingeklemmten piezoelektrischen Bauelementes nicht auf die weiteren Elemente der Haltung übertragen. Dementsprechend kann das Kontaktelement für eine mechanische Entkopplung des piezoelektrischen Bauelements und der Halterung sorgen. Dadurch kann sichergestellt werden, dass die Halterung die Schwingung des piezoelektrischen Bauelementes nicht beeinflusst. Auf diese Weise kann insbesondere eine Halterung konstruiert werden, die sich nicht negativ auf die Funktionsweise des von ihr gehaltenen piezoelektrischen Bauelementes auswirkt und dieses nicht stört.

Zwischen dem Kontaktelement, das ein leitfähiges Gummimaterial aufweist, und dem piezoelektrischen Bauelement kann kein mechanischer Abrieb entstehen. Dadurch kann sichergestellt werden, dass auch ein piezoelektrisches Bauelement, das über eine lange Zeit in der Klemmvorrichtung eingeklemmt bleibt, sich hinsichtlich seiner Kontakteigenschaften und seines Schwingungsverhaltens nicht verändert.

Bei dem Einklemmen mit den Kontaktelementen kann vermieden werden, dass unkontrollierte mechanische Spannungen entstehen. Diese könnten ansonsten das piezoelektrische Bauelement beschädigen und beispielsweise zu Brüchen des piezoelektrischen Bauelementes führen. Durch solche unkontrollierten mechanischen Spannungen könnten ansonsten auch disharmonische Schwingungen angeregt werden, was jedoch durch die elastischen Kontaktelemente verhindert wird.

Die Halterung kann derart ausgestaltet sein, dass keine Verlötung zwischen dem piezoelektrischen Bauelement und Elementen der Halterung vorhanden ist. Ferner kann die Halterung derart ausgestaltet sein, dass keine dauerhafte metallische Verbindung zwischen der Klemmvorrichtung und dem piezoelektrischen Bauelement vorgesehen ist. Vielmehr kann das piezoelektrische Bauelement durch eine Klemmkraft, die über die Kontaktelemente auf das piezoelektrische Bauelement wirkt, gehalten werden. Auf diese Weise kann verhindert werden, dass metallische Verbindungen und Lötstellen vorhanden sind, die mechanische Schwachstellen der Halterung ausbilden könnten. Insbesondere besteht bei einer Dauerschwingbelastung, bei der das piezoelektrische Bauelement eine Vielzahl von Schwingungszyklen durchläuft, die Gefahr eines Bruchs einer metallischen Verbindung oder einer Lötstelle. Diese Gefahr eines Bruchs kann durch die Befestigung unter Nutzung einer Klemmkraft vermieden werden. Die Klemmkraft kann derart stark sein, dass sie eine sichere Fixierung des piezoelektrischen Bauelementes ermöglicht.

Aufgrund der Elastizität des Kontaktelementes kann vermieden werden, dass durch die Klemmkraft eine Kerbe in das piezoelektrische Bauelement gepresst wird. Diese würde ähnlich wie ein mechanischer Abrieb die Eigenschaften des piezoelektrischen Bauelementes negativ beeinflussen.

Die Klemmvorrichtung kann lösbar sein und einen geöffneten Zustand aufweisen, in dem das piezoelektrische Bauelement aus der Halterung entnehmbar ist. Insbesondere kann das piezoelektrische Bauelement zerstörungsfrei aus der Halterung entnehmbar sein. Dementsprechend kann das Bauelement entnommen werden, ohne dabei das Bauelement oder die Halterung zu beschädigen. Eine lösbare Klemmvorrichtung kann somit den Austausch des piezoelektrischen Bauelementes ermöglichen.

Bei der Klemmvorrichtung kann es sich beispielsweise um eine Schnappklemmung handeln. Die Klemmvorrichtung kann derart ausgestaltet sein, dass sie eine einfache Montage und Demontage des piezoelektrischen Bauelementes in der Halterung ermöglicht. Im Gegensatz zu den Halterungen, bei denen das Bauelement fest mit der Halterung verlötet wird, kann es die Halterung somit hier ermöglichen, ein beschädigtes piezoelektrisches Bauelement auszutauschen und durch ein anderes piezoelektrisches Bauelement zu ersetzen. Damit kann erreicht werden, dass in dem Fall eines Ausfalls des piezoelektrischen Bauelementes nur dieses ausgetauscht werden muss und die übrigen Bauteile weiter verwendet werden können. Die Klemmvorrichtung kann zwei Arme aufweisen, zwischen denen das piezoelektrische Bauelement in dem geschlossenen Zustand eingeklemmt ist. Alternativ kann die Klemmvorrichtung einen Arm aufweisen, wobei das piezoelektrische Bauelement in dem geschlossenen Zustand zwischen dem Arm und einer Leiterplatine eingeklemmt ist. Im zweiten Fall kann das Kontaktelement unmittelbar an auf der Leiterplatine ausgebildeten Leiterbahnen anliegen und das piezoelektrische Bauelement direkt mit den Leiterbahnen der Leiterplatine elektrisch kontaktieren.

Die Halterung weist ferner ein Anschlusselement auf, wobei das Anschlusselement im geschlossenen Zustand der Klemmvorrichtung zwischen der Klemmvorrichtung und einem der Kontaktelemente eingeklemmt ist und wobei das Anschlusselement das Kontaktelement elektrisch kontaktiert. Insbesondere kann die Halterung zwei Anschlusselemente aufweisen, wobei jedes der Anschlusselemente im geschlossenen Zustand zwischen der Klemmvorrichtung und einem der Kontaktelemente eingeklemmt ist und wobei jedes der Anschlusselemente jeweils eines der Kontaktelemente elektrisch kontaktiert. Bei mindestens einem Anschlusselement handelt es sich erfindungsgemäß um einen metallischen Draht. Das Kontaktelement kann für eine mechanische Entkopplung zwischen den metallischen Drähten und dem piezoelektrischen Bauelement sorgen.

Da das Kontaktelement, das ein leitfähiges Gummimaterial aufweist, zwischen dem Anschlusselement und der Außenseite des piezoelektrischen Bauelementes angeordnet ist, wird vermieden, dass das metallische Anschlusselement direkt in mechanischem Kontakt mit dem piezoelektrischen Bauelement kommt und dieses bei Dauerbetrieb beschädigt, beispielsweise durch einen mechanischen Abrieb oder durch das Einpressen einer Kerbe.

Die Halterung kann ein Gehäuse aufweisen, wobei zumindest ein Arm durch das Gehäuse der Halterung gebildet wird. Der Arm kann insbesondere durch ein Gehäuseteil gebildet werden, der an einem weiteren Gehäuseteil lösbar befestigt werden kann. Die Halterung kann derart ausgestaltet sein, dass die Klemmvorrichtung in den geöffneten Zustand versetzt wird, wenn das Gehäuse geöffnet wird. Beim Öffnen des Gehäuses wird der Gehäuseteil, der den Arm ausbildet, von dem weiteren Gehäuseteil gelöst.

Die Klemmvorrichtung kann derart ausgestaltet sein, dass beide Arme der Klemmvorrichtung durch ein Gehäuseteil der Halterung gebildet werden.

Es kann somit die Klemmvorrichtung derart konstruiert sein, dass sie keine zusätzlichen Bauteile erfordert, da zumindest ein Arm durch das stets vorhandene Gehäuse ausgebildet wird.

Die Halterung kann derart ausgestaltet sein, dass sie das piezoelektrische Bauelement freitragend hält. Dementsprechend sind neben den Elementen der Halterung, insbesondere der Klemmvorrichtung, keine weiteren Bauteile zur mechanischen Befestigung des piezoelektrischen Bauelements erforderlich.

Das piezoelektrische Bauelement kann dabei nur an den Punkten direkt mechanisch kontaktiert sein, an denen die Kontaktelemente, die ein leitfähiges Gummimaterial aufweisen oder aus einem leitfähigen Gummimaterial bestehen, direkt an dem piezoelektrischen Bauelement anliegen.

Das leitfähige Gummimaterial kann ein Silikongummi mit beigemischten Metallpartikeln sein. Beispielsweise kann es sich um einen Elastomer auf Silikonbasis handeln, dem Graphit oder Silberpartikel beigemischt sind. Die beigemischten Metallpartikel können dabei sicherstellen, dass das Kontaktelement leitfähig ist.

Die Größe und die Form des Kontaktelementes hängen dabei von der Ausgestaltung des zu haltenden piezoelektrischen Bauelementes ab. Das Kontaktelement kann beispielsweise scheibenförmig oder quaderförmig sein.

Ein weiterer Aspekt betrifft eine Anordnung, die eine oben beschriebene Halterung sowie ein piezoelektrisches Bauelement aufweist.

Bei dem piezoelektrischen Bauelement kann es sich beispielsweise um einen piezoelektrischen Transformator handeln. Bei dem piezoelektrischen Bauelement kann es sich um ein Vielschichtbauelement handeln. Das piezoelektrische Bauelement kann einen Stapel aufweisen, in dem abwechselnd piezoelektrische Schichten und Innenelektroden angeordnet sind. Ferner kann das piezoelektrische Bauelement auf seinen Außenseiten eine Außenelektrode aufweisen, die im geschlossenen Zustand der Klemmvorrichtung an den Kontaktelementen anliegt. Dementsprechend kann eine elektrische Spannung über die Kontaktelemente auf die Außenelektroden übertragen werden. Die Außenelektrode kann ferner mit den Innenelektroden elektrisch kontaktiert sein.

Die Klemmvorrichtung kann derart angeordnet sein, dass die Kontaktelemente des piezoelektrischen Bauelementes in einem Bereich mechanisch befestigt und elektrisch kontaktiert sind, in dem sich bei Betrieb des piezoelektrischen Bauelements mit seiner Resonanzfrequenz ein Schwingungsknoten ausbildet. Im Bereich des Schwingungsknotens bewegt sich das piezoelektrische Bauelement dementsprechend im Betrieb nur minimal. Dementsprechend entstehen hier deutlich geringere mechanische Belastungen als in den Bereichen, in denen sich Schwingungsbäuche ausbilden. Die Resonanzfrequenz wird durch die Geometrie des piezoelektrischen Bauelements bestimmt. Sie kann zwischen 10 und 1000 kHz betragen. Vorzugsweise kann die Resonanzfrequenz zwischen 20 und 100 kHz und beispielsweise 50 kHz betragen.

Im Folgenden wird die Erfindung anhand der Figuren und Ausführungsbeispiele beschrieben.
- Figur 1: zeigt eine schematische Ansicht eines piezoelektrischen Bauelementes,
- Figur 2: zeigt einen Querschnitt durch eine Halterung gemäß einem ersten Ausführungsbeispiel, wobei ein piezoelektrisches Bauelement in der Halterung gehalten wird,
- Figur 3: zeigt ebenfalls die Halterung gemäß dem ersten Ausführungsbeispiel, und
- Figur 4: zeigt ein zweites Ausführungsbeispiel der Halterung.

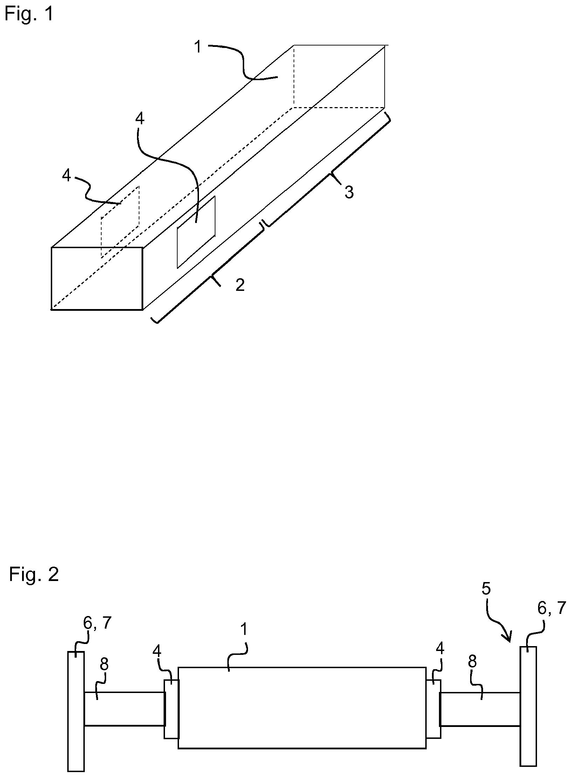

Figur 1 zeigt ein piezoelektrisches Bauelement 1. Bei dem piezoelektrischen Bauelement 1 handelt es sich um einen piezoelektrischen Transformator.

Das piezoelektrische Bauelement 1 weist eine Eingangsseite 2 und eine Ausgangsseite 3 auf. Auf der Eingangsseite 2 weist das Bauelement 1 eine Vielschichtstruktur auf, bei der piezoelektrische Schichten und dazwischen angeordnete erste und zweite Innenelektroden übereinandergestapelt sind. Die piezoelektrischen Schichten weisen eine Blei-Zirkonat-Titanat (PZT) Keramik auf. Auf der Eingangsseite 2 sind die piezoelektrischen Schichten in Stapelrichtung polarisiert. Die Innenelektroden bestehen aus Kupfer.

In einer Stapelrichtung sind dabei zwischen zwei piezoelektrischen Schichten jeweils abwechselnd eine erste Innenelektrode und eine zweite Innenelektrode angeordnet. Die ersten Innenelektroden sind zu einer ersten Außenseite des piezoelektrischen Bauelements 1 herausgeführt und von einer zweiten Außenseite beabstandet. Die zweiten Innenelektroden sind zu der ersten Außenseite beabstandet und zu der zweiten Außenseite herausgeführt. Ferner sind auf der ersten Außenseite und der zweiten Außenseite jeweils Außenelektroden 4 angeordnet, die mit den zu der jeweiligen Außenseite herausgeführten Innenelektroden elektrisch kontaktiert sind.

Die Außenelektroden 4 auf der ersten und der zweiten Außenfläche sind dabei in einem Knotenpunkt angeordnet, der sich bei Betrieb des piezoelektrischen Bauelementes 1 mit seiner Resonanzfrequenz oder bei Betrieb des Bauelements 1 in der zweiten harmonischen Schwingung ausbildet. Der Knotenpunkt kann in longitudinaler Richtung bei einem Viertel der Länge des piezoelektrischen Bauelementes 1 angeordnet sein. Wie im Folgenden beschrieben wird, ist eine Halterung 5 dazu ausgestaltet, an diesem Knotenpunkt das piezoelektrische Bauelement 1 mechanisch zu befestigen.

Auf der Ausgangsseite 3 weist das piezoelektrische Bauelement 1 eine monolithische Struktur auf. Insbesondere weist die Ausgangsseite 3 das gleiche piezoelektrische Material wie die Eingangsseite 2 auf. Die Ausgangsseite 3 des piezoelektrischen Bauelementes 1 ist in longitudinaler Richtung polarisiert. Ferner ist eine auf der Ausgangsseite 3 angeordnete Endfläche des piezoelektrischen Bauelementes 1 metallisiert.

Bei Betrieb des piezoelektrischen Bauelementes 1 wird an die Außenelektroden 4 auf der Eingangsseite 2 eine Wechselspannung angelegt, die piezoelektrische Schwingungen in Stapelrichtung zwischen den Innenelektroden anregt. Dadurch kann sich eine Welle ausbilden, die sich in longitudinaler Richtung fortsetzt. Auf diese Weise kann an der metallisierten Endfläche auf der Ausgangsseite 3 eine Hochspannung erzeugt werden. Mittels dieser Hochspannung kann ein Gas, beispielsweise Luft, ionisiert werden und auf diese Weise kann atmosphärisches, nicht-thermisches Plasma erzeugt werden.

Bei seinem Betrieb führt das piezoelektrische Bauelement 1 Schwingungen aus, die mit Längenänderungen des piezoelektrischen Bauelementes 1 einhergehen.

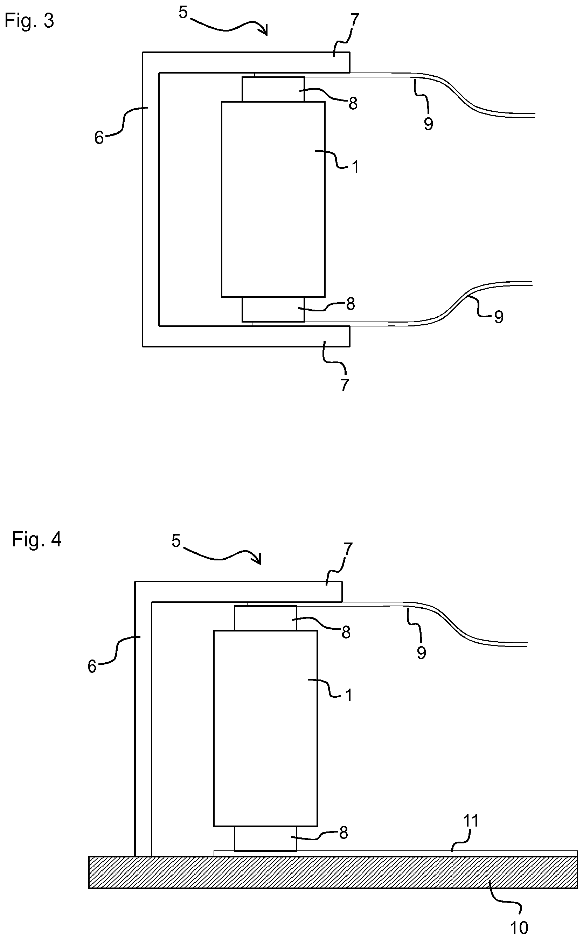

Figuren 2 und 3 zeigen jeweils eine Halterung 5 für das piezoelektrische Bauelement 1 in einem Querschnitt. Die Halterung 5 weist eine Klemmvorrichtung 6 auf. Die Klemmvorrichtung 6 weist zwei Arme 7 auf. Dabei können die Arme 7 der Klemmvorrichtung 6 durch Gehäuseteile der Halterung 5 gebildet werden.

Ferner weist die Klemmvorrichtung 6 zwei Kontaktelemente 8 auf. Die Kontaktelemente 8 werden in einem geschlossenen Zustand der Klemmvorrichtung 6 mit dem piezoelektrischen Bauelement 1 verklemmt. Dadurch wird das piezoelektrische Bauelement 1 mechanisch befestigt.

Ein erstes Kontaktelement 8 liegt dabei an der Außenelektrode 4 des piezoelektrischen Bauelementes 1 auf der ersten Außenfläche an und das zweite Kontaktelement 8 liegt an der Außenelektrode 4 des piezoelektrischen Bauelementes 1 auf der zweiten Außenseite an. Die Kontaktelemente 8 weisen ein leitfähiges Gummimaterial auf. Dementsprechend ermöglichen es die Kontaktelemente 8, eine elektrische Spannung auf die Außenelektroden 4 des piezoelektrischen Bauelementes 1 zu übertragen.

Ferner weist die Halterung 5 Anschlusselemente 9 auf. Bei den Anschlusselementen 9 handelt es sich um metallische Drähte. Ein erstes Anschlusselement 9 ist zwischen dem ersten Arm 7 der Klemmvorrichtung 6 und dem ersten Kontaktelement 8 eingeklemmt. Ein zweites Anschlusselement 9 ist zwischen dem zweiten Arm 7 der Klemmvorrichtung 6 und dem zweiten Kontaktelement 8 eingeklemmt. Die Anschlusselemente 9 ermöglichen eine weitere Kontaktierung und können beispielsweise die Kontaktelemente 8 elektrisch mit einer Schaltung, die auf einer Leiterplatine ausgebildet ist, verbinden.

Wird ein Gehäuse der Halterung 5 geöffnet, so wird dadurch die Klemmvorrichtung 6 gelöst und von ihrem geschlossenen Zustand in einen geöffneten Zustand versetzt. In dem geöffneten Zustand hält die Klemmvorrichtung 6 das piezoelektrische Bauelement 1 nicht mehr fest und dieses kann aus der Halterung 5 entnommen werden.

Das piezoelektrische Bauelement 1 ist in der Halterung 5 freitragend befestigt. Es wird nur durch die von der Klemmvorrichtung 6 über die Kontaktelemente 8 auf das Bauelement 1 ausgeübte Klemmkraft gehalten. Insbesondere berührt das Bauelement 1 lediglich die beiden Kontaktelemente 8 und wird ansonsten von keinem weiteren Element der Halterung 5 berührt.

In einem alternativen Ausführungsbeispiel können in einem oder in mehreren weiteren Schwingungsknoten des piezoelektrischen Bauelements 1 weitere Halterungselemente angeordnet sein, die das piezoelektrische Bauelement mechanisch befestigen. Diese weiteren Halterungselemente können beispielsweise ebenfalls eine Klemmvorrichtung aufweisen. Die weiteren Halterungselemente sind jedoch nicht für das Übertragen einer elektrischen Energie vorgesehen oder ausgebildet.

Figur 4 zeigt ein zweites Ausführungsbeispiel der Halterung 5. Das zweite Ausführungsbeispiel unterscheidet sich dadurch von dem ersten Ausführungsbeispiel, dass die Klemmvorrichtung 6 nur einen Arm 7 aufweist. Das piezoelektrische Bauelement 1 ist in dem geschlossenen Zustand der Klemmvorrichtung 6 zwischen diesem Arm 7 und einer Leiterplatine 10 eingeklemmt, wobei zwischen dem Arm 7 und dem piezoelektrischen Bauelement 1 sowie zwischen der Leiterplatine 10 und dem piezoelektrischen Bauelement 1 jeweils ein Kontaktelement 8, das einen leitfähiges Gummimaterial aufweist, angeordnet ist. Das Kontaktelement 8 kann dabei unmittelbar an einer Leiterbahn 11 der Leiterplatine 10 anliegen und so das piezoelektrische Bauelement 1 mit der auf der Leiterplatine 10 ausgebildeten Schaltung kontaktieren. Der erste Arm 7 der Klemmvorrichtung 6 kann wiederum durch ein Gehäuseteil ausgebildet sein, sodass bei einem Öffnen des Gehäuses die Klemmvorrichtung 6 gelöst wird.

### Bezugszeichenliste

- 1: piezoelektrisches Bauelement
- 2: Eingangsseite
- 3: Ausgangsseite
- 4: Außenelektrode
- 5: Halterung
- 6: Klemmvorrichtung
- 7: Arm
- 8: Kontaktelement
- 9: Anschlusselement
- 10: Leiterplatine
- 11: Leiterbahn

## Patentansprüche

1. Halterung (5) für ein piezoelektrisches Bauelement (1), aufweisend eine Klemmvorrichtung (6) und zwei Kontaktelemente (8), die ein leitfähiges Gummimaterial aufweisen,
wobei die Klemmvorrichtung (6) dazu ausgestaltet ist, das piezoelektrische Bauelement (1) in einem geschlossenen Zustand zwischen den Kontaktelementen (8) festzuklemmen, und wobei die Kontaktelemente (8) das piezoelektrische Bauelement (1) im geschlossenen Zustand der Klemmvorrichtung (6) elektrisch kontaktieren,
wobei die Halterung (5) ferner ein Anschlusselement (9) aufweist, wobei das Anschlusselement (9) im geschlossenen Zustand der Klemmvorrichtung (6) zwischen der Klemmvorrichtung (6) und einem der Kontaktelemente (8) eingeklemmt ist und wobei das Anschlusselement (9) das Kontaktelement (8) elektrisch kontaktiert,
**dadurch gekennzeichnet, dass** es sich bei dem Anschlusselement (9) um einen metallischen Draht handelt.

2. Halterung (5) gemäß Anspruch 1,
wobei die Klemmvorrichtung (6) lösbar ist und einen geöffneten Zustand aufweist, in dem das piezoelektrische Bauelement (1) aus der Halterung (5) entnehmbar ist.

3. Halterung (5) gemäß einem der vorherigen Ansprüche,
wobei die Klemmvorrichtung (6) zwei Arme (7) aufweist, zwischen denen das piezoelektrische Bauelement (1) in dem geschlossenen Zustand eingeklemmt ist.

4. Halterung (5) gemäß einem der Ansprüche 1 bis 2,
wobei die Klemmvorrichtung (6) einen Arm (7) aufweist, wobei das piezoelektrische Bauelement (1) in dem geschlossenen Zustand zwischen dem Arm (7) und einer Leiterplatine (10) eingeklemmt ist.

5. Halterung (5) gemäß einem der Ansprüche 3 oder 4,
wobei die Halterung (5) ein Gehäuse aufweist,
wobei zumindest ein Arm (7) durch das Gehäuse der Halterung (5) gebildet wird, und
wobei die Halterung (5) derart ausgestaltet ist, dass die Klemmvorrichtung (6) in den geöffneten Zustand versetzt wird, wenn das Gehäuse geöffnet wird.

6. Halterung (5) gemäß einem der vorherigen Ansprüche,
wobei die Halterung (5) dazu ausgestaltet ist, das piezoelektrische Bauelement (1) freitragend zu halten.

7. Halterung (5) gemäß einem der vorherigen Ansprüche,
wobei das leitfähige Gummimaterial ein Silikongummi mit beigemischten Metallpartikeln ist.

8. Anordnung aufweisend eine Halterung (5) gemäß einem der vorherigen Ansprüche und ein piezoelektrisches Bauelement (1) .

9. Anordnung gemäß Anspruch 8,
wobei die Klemmvorrichtung (6) derart angeordnet ist, dass die Kontaktelemente (8) das piezoelektrische Bauelement (1) in einem Bereich mechanisch befestigen und elektrische kontaktieren, in dem sich bei Betrieb des piezoelektrischen Bauelements (1) mit seiner Resonanzfrequenz ein Schwingungsknoten ausbildet.

10. Anordnung gemäß Anspruch 8 oder 9,
wobei es sich bei dem piezoelektrischen Bauelement (1) um einen piezoelektrischen Transformator handelt.

## Claims

1. Holder (5) for a piezoelectric component (1), having a clamping device (6) and two contact elements (8) which contain a conductive rubber material,
wherein the clamping device (6) is designed to clamp the piezoelectric component (1) between the contact elements (8) in a closed state, and
wherein the contact elements (8) are in electrical contact with the piezoelectric component (1) in the closed state of the clamping device (6),
wherein the holder (5) furthermore has a connector element (9), wherein the connector element (9) is clamped between the clamping device (6) and one of the contact elements (8) in the closed state of the clamping device (6) and wherein the connector element (9) is in electrical contact with the contact element (8), **characterized in that** the connector element (9) is a metal wire.

2. Holder (5) according to Claim 1,
wherein the clamping device (6) is releasable and has an open state in which the piezoelectric component (1) can be removed from the holder (5).

3. Holder (5) according to one of the preceding claims,
wherein the clamping device (6) has two arms (7) between which the piezoelectric component (1) is clamped in the closed state.

4. Holder (5) according to either of Claims 1 and 2,
wherein the clamping device (6) has one arm (7), wherein the piezoelectric component (1) is clamped between the arm (7) and a printed circuit board (10) in the closed state.

5. Holder (5) according to either of Claims 3 and 4,
wherein the holder (5) has a housing,
wherein at least one arm (7) is formed by the housing of the holder (5), and
wherein the holder (5) is designed such that the clamping device (6) is transferred into the open state when the housing is opened.

6. Holder (5) according to one of the preceding claims,
wherein the holder (5) is designed to hold the piezoelectric component (1) in a self-supporting manner.

7. Holder (5) according to one of the preceding claims,
wherein the conductive rubber material is a silicone rubber with added metal particles.

8. Arrangement having a holder (5) according to one of the preceding claims and a piezoelectric component (1).

9. Arrangement according to Claim 8,
wherein the clamping device (6) is arranged such that the contact elements (8) secure the piezoelectric component (1) mechanically and are in electrical contact therewith in a region in which an oscillation node forms during operation of the piezoelectric component (1) at its resonant frequency.

10. Arrangement according to Claim 8 or 9,
wherein the piezoelectric component (1) is a piezoelectric transformer.

## Revendications

1. Support (5) pour un composant piézoélectrique (1), comprenant un dispositif de serrage (6) et deux éléments de contact (8) qui possèdent un matériau conducteur à base de caoutchouc,
le dispositif de serrage (6) étant configuré pour serrer le composant piézoélectrique (1) entre les éléments de contact (8) dans un état fermé, et
les éléments de contact (8) venant en contact électrique avec le composant piézoélectrique (1) à l'état fermé du dispositif de serrage (6),
le support (5) possédant en outre un élément de raccordement (9), l'élément de raccordement (9), à l'état fermé du dispositif de serrage (6), étant coincé entre le dispositif de serrage (6) et l'un des éléments de contact (8) et l'élément de raccordement (9) venant en contact électrique avec l'élément de contact (8), **caractérisé en ce que**
l'élément de raccordement (9) est un fil métallique.

2. Support (5) selon la revendication 1, le dispositif de serrage (6) pouvant être desserré et possédant un état ouvert dans lequel le composant piézoélectrique (1) peut être retiré hors du support (5).

3. Support (5) selon l'une des revendications précédentes, le dispositif de serrage (6) possédant deux bras (7) entre lesquels le composant piézoélectrique (1) est coincé à l'état fermé.

4. Support (5) selon l'une des revendications 1 à 2, le dispositif de serrage (6) possédant un bras (7), le composant piézoélectrique (1) à l'état fermé étant coincé entre le bras (7) et une carte à circuit imprimé (10).

5. Support (5) selon l'une des revendications 3 à 4, le support (5) possédant un boîtier, au moins un bras (7) étant formé par le boîtier du support (5) et le support (5) étant configuré de telle sorte que le dispositif de serrage (6) à l'état ouvert est décalé lorsque le boîtier est ouvert.

6. Support (5) selon l'une des revendications précédentes, le support (5) étant configuré pour maintenir le composant piézoélectrique (1) de manière non soutenue.

7. Support (5) selon l'une des revendications précédentes, le matériau conducteur à base de caoutchouc étant un caoutchouc de silicone auquel sont mélangées des particules métalliques.

8. Arrangement comportant un support (5) selon l'une des revendications précédentes et un composant piézoélectrique (1).

9. Arrangement selon la revendication 8, le dispositif de serrage (6) étant disposé de telle sorte que les éléments de contact (8) fixent mécaniquement le composant piézoélectrique (1) et viennent en contact électrique avec celui-ci dans une zone dans laquelle se forme un nœud oscillatoire lors du fonctionnement du composant piézoélectrique (1) avec sa fréquence de résonance.

10. Arrangement selon la revendication 8 ou 9, le composant piézoélectrique (1) étant un transformateur piézoélectrique.
